# Europäisches Patentamt

(19) **European Patent Office**

**Office européen des brevets**

(11) Publication number: **0 104 754**
**B1**

(12) **EUROPEAN PATENT SPECIFICATION**

(45) Date of publication of patent specification: **13.08.86**

(51) Int. Cl.⁴: **H 01 L 29/08,** H 01 L 29/52

(21) Application number: **83304814.3**

(22) Date of filing: **19.08.83**

(54) **Metal insulator semiconductor device with source region connected to a reference voltage.**

(30) Priority: **27.09.82 JP 167920/82**

(43) Date of publication of application:
**04.04.84 Bulletin 84/14**

(45) Publication of the grant of the patent:
**13.08.86 Bulletin 86/33**

(84) Designated Contracting States:
**DE FR GB**

(56) References cited:
**DE-A-2 825 433**
**GB-A-2 052 860**
**GB-A-2 075 255**
**US-A-3 649 843**
**US-A-3 909 306**

(73) Proprietor: **FUJITSU LIMITED**
**1015, Kamikodanaka Nakahara-ku**
**Kawasaki-shi Kanagawa 211 (JP)**

(72) Inventor: **Shirato, Takehide**
**6-26 Sengen-cho**
**Hiratsuka-shi Kanagawa 254 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

**Description**

The present invention relates to a semiconductor device and more particularly to a semiconductor device comprising metal insulator semiconductor (MIS) field effect transistors (FET) in which a wiring line for a reference voltage supply is not needed.

Generally a semiconductor device such as a logic integrated circuit or a microprocessor device has a large number of wiring lines connecting various elements. Such wiring lines include voltage supply lines, various signal lines, input lines, output lines, and ground lines. These wiring lines occupy a relatively large area of the semiconductor device and generally determine the scale of integration of an integrated circuit. Ground lines in particular, occupy a considerable area and complicate the pattern layout of the integrated circuit.

In prior integrated circuits comprising MIS FETs the source region of each MIS FET formed in the semiconductor substrate is usually connected to a reference voltage wiring line through a contact window that opens onto the surface of the substrate. In many cases, the semiconductor substrate is also supplied with a reference voltage using a back electrode attached to the rear face of the integrated circuit chip. DE—A—2825433 discloses a semiconductor device including MIS FETS with the sources of the MIS FET's connected to a reference voltage source through a wiring line extending through a contact window and over the surface of the device. In this device it is desired to have the substrate at the same potential as the source region and, to achieve this without the need for a back electrode attached to the rear face of the integrated circuit chip an alloy region is formed beneath the source electrode to connect the source region directly to the substrate. In this way the potential on a wiring line leading through a contact region and into contact with the source electrode is also connected to the substrate without a back electrode.

According to this invention a semiconductor device comprising at least one metal-insulator-semiconductor field effect transistor formed on a semiconductor substrate, and field effect transistor comprising a drain region and a source region of one conductivity type formed in a region of the semiconductor substrate of another conductivity type, also includes means forming a direct electrical connection between the source region and the semiconductor substrate with said means providing the sole electrical connection between said source region and a wiring line provided on the back surface of the substrate.

Particular embodiments of semiconductor devices in accordance with this invention will now be described and contrasted with convention devices with reference to the accompanying drawings; in which:—

Figure 1 is a diagrammatic plan of the pattern layout of a conventional semiconductor device;

Figure 2 is a diagrammtic cross section of a conventional semiconductor device;

Figure 3 is a plan of a portion of the pattern layout of a conventional semiconductor device;

Figure 4 is a cross section through a portion of a semiconductor device in accordance with a first embodiment of the present invention;

Figure 5 is a diagrammatic cross section of the first embodiment of semiconductor device;

Figure 6 is a diagrammatic plan of the pattern layout of the semiconductor device in accordanced with this invention;

Figure 7 is a plan of the portion of the semiconductor device shown in Figure 4;

Figure 8 is a cross section of a second embodiment of a semiconductor device in accordance with the present invention;

Figure 9 is a cross section of a third embodiment of a semiconductor device in accordance with the present invention; and,

Figure 10 is a diagrammatic cross section of a fourth embodiment of a semiconductor device in accordance with the present invention/

Before describing the preferred embodiments of the present invention, one example of a prior art semiconductor device is described with reference to the drawings for the purpose of comparison.

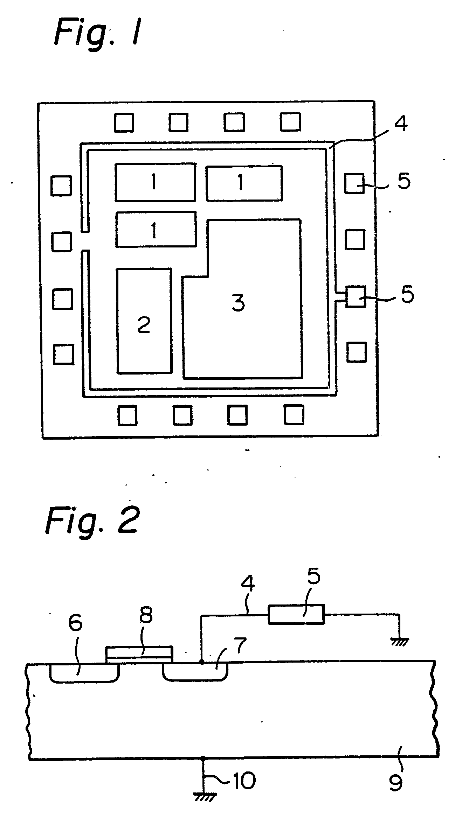

Figure 1 is a schematic plan view of a prior art integrated circuit semiconductor device. In the integrated circuit of Fig. 1, reference numeral 1 is a D/A (digital-to-analog) converter with 6-bit precision, 2 is an address recorder, 3 is a D/A counter with 13-bit precision, 4 is a reference voltage (ground) wiring line, and 5 is a pad. The integrated circuit of Fig. 1 comprises MIS FET's.

Figure 2 is a schematic cross-sectional view of an MIS FET in the integrated circuit of Fig. 1. In Fig. 2, reference numeral 6 is a drain region, 7 is a source region, 8 is a gate electrode, 9 is a semiconductor substrate, and 10 is a ground line. The semiconductor substrate 9 is of one conductivity type, and the drain and source regions 6 and 7 are of the opposite conductivity type. Since a pn junction is formed between the source region 7 and the semiconductor substrate 9, the source region 7 is not electrically connected to the semiconductor substrate 9. Thus, in order to keep the potential of the source region 7 at the ground level, the source region 7 is connected to the reference voltage wiring line 4 at the surface of the substrate 9, the reference voltage wiring line 4 is connected to one pad 5, and the pad 5 is connected externally to the ground.

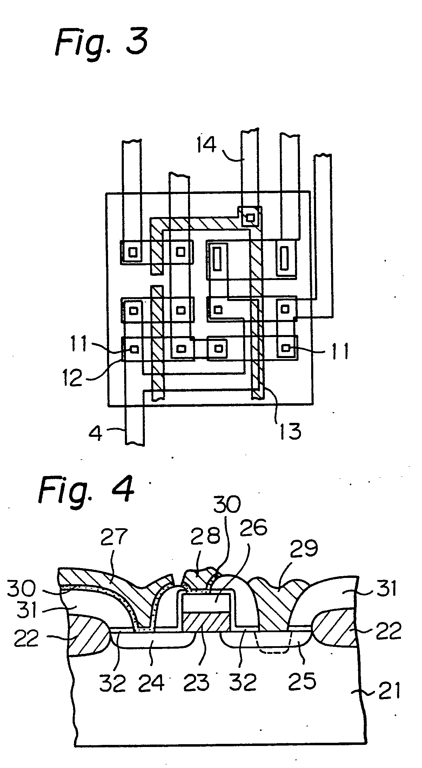

Figure 3 is the wiring pattern layout of a main portion of the semiconductor device of Fig. 1. In Fig. 3, reference numeral 11 is an electrode contact window, 12 is a diffusion layer for drain and source regions, 13 is a polycrystalline silicon layer forming a gate electrode and a wiring line for it, and 14 and 4 are aluminum (Al) wiring lines. As seen from Figs. 1 and 3, the wiring lines, especially the ground wiring lines, occupy a considerably large area. These largely determine the scale of integration of the integrated circuit and complicate the pattern layout of the integrated circuit.

A semiconductor device in accordance with a first embodiments of the present invention will now be described. Figure 4 is a cross-sectional view of a MIS FET included in a semiconductor device according to the invention. In Fig. 4, reference numeral 21 is a p-type silicon substrate, 22 is a field oxide film, 23 is a gate oxide film, 24 is a drain region, 25 is a source region, 26 is a gate electrode, 27 is an Al drain electrode wiring line, 28 is a gate wiring line, 29 is a source electrode, 30 is a polycrystalline silicon film, 31 is an insulator film, and 32 is a thin oxide film.

In the MIS FET of Fig. 4, the source electrode 29 is not connected to any wiring line to which a reference voltage is applied. Instead, the source region is directly connected to the substrate 21 as described below. The source electrode 29 is formed so as to contact the source region 25 without a polycrystalline silicon layer under the source electrode 29. By carrying out a heat treatment of approximately 480°C, the aluminum in the source electrode 29 is impregnated into the source region 25. Some of this aluminum is further impregnated into the substrate 21 through the source region 25. The source region 25 and the substrate 21 are therefore electrically connected through the impregnated aluminum.

The potential of the source region 25 thus becomes equal to that of the substrate 21. Since the substrate 21 is connected to a ground line at the back surface (opposite surface from that on which active elements are formed), the potential of the substrate 21 is equal to the ground level, which in turn makes the potential of the source region 25 equal to the ground level.

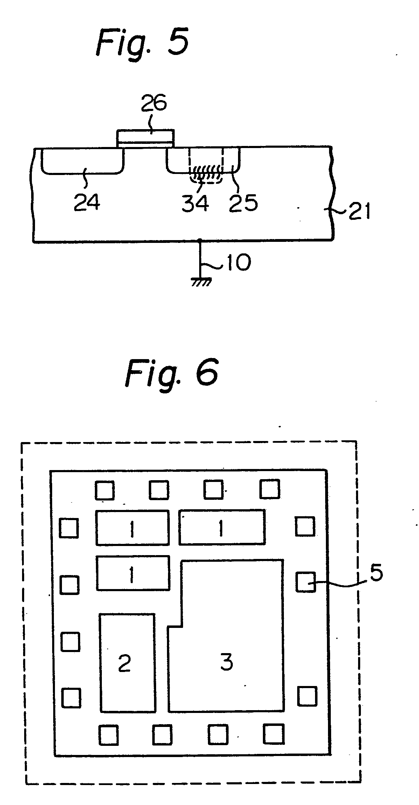

Figure 5 is a schematic cross-sectional view of the semiconductor device of Fig. 4. In Fig. 5, portions corresponding to those in Fig. 4 are designated by the same reference numerals. Reference numeral 34 is the impregnated aluminum. As shown in Fig. 4, in the semiconductor device according to the present invention, no wiring line for connecting the source region 25 to the reference voltage is formed on the surface of the substrate 21.

Figure 6 is a schematic plan view of the semiconductor device according to the present invention, in which all the source regions having the reference voltage are connected directly to the substrate as described above. In such a semiconductor device, no wiring lines 4 for the reference voltage are necessary. Thus, the surface area devoted to circuiting in the semiconductor device of Fig. 6 is decreased by an area corresponding to the reference voltage wiring lines 4, as compared with the surface area of the prior art semiconductor device of Fig. 1. An outline of the prior art semiconductor device is shown with a broken line in Fig. 6 for the purpose of comparison.

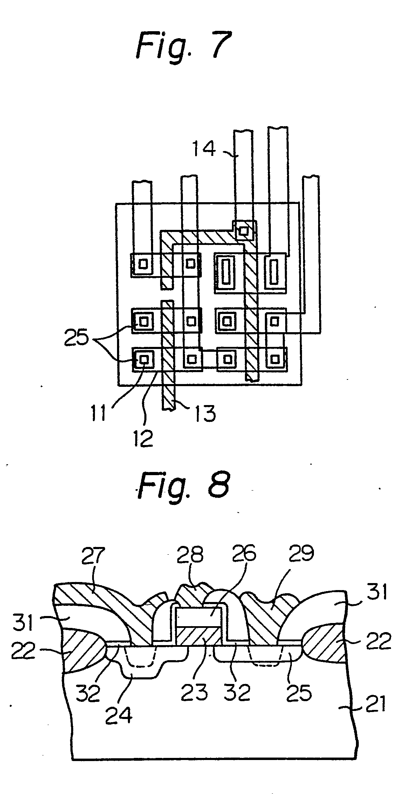

Figure 7 is a pattern layout of a main portion of the semiconductor device of Fig. 6. In Fig. 6, corresponding portions are given the same reference numerals as in Fig. 3. As seen by comparing Fig. 7 with Fig. 3 the pattern layout of the semiconductor device according to the present invention is simplified by eliminating the reference voltage wiring line led out from the source electrode.

Figure 8 is a cross-sectional view of a semiconductor device in accordance with a second embodiment of the present invention. In Fig. 8, corresponding portions are given the same reference numerals as in Fig. 4. In the semiconductor device of Fig. 8, no polycrystalline layer is formed under the drain electrode 27. In addition, the diffusion layer for the drain region 24 is formed in such a manner that the depth of the layer at the portion below the contact window for the drain electrode 27 is greater than the other portions. As a result, the aluminum that impregnates the drain region 24 from drain electrode 27 does not reach the silicon substrate 21. On the other hand, the depth of the diffusion layer for the source region 25 is not so great that the impregnated aluminum from the source electrode 29 reaches the silicon substrate 21. Accordingly, in the semiconductor device of Fig. 8, the source region 25 is connected directly to the substrate 21 by the impregnated aluminum, but the drain region 24 is electrically isolated from the substrate 21 by the pn junction formed therebetween. The elimination of the process for forming a polycrystalline silicon layer simplifies the manufacture of the semiconductor device of Fig. 8,.

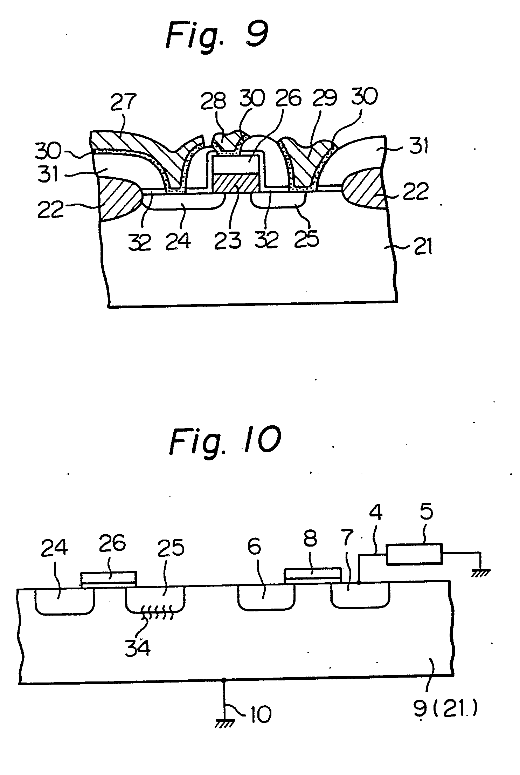

Figure 9 is a cross-sectional view of a semiconductor device in accordance with a third embodiment of the present invention. In Fig. 9, corresponding portions are given the same reference numerals as in Fig. 4. The construction of the semiconductor device of Fig. 9 is essentially identical to that of the semiconductor device of Fig. 4, except that the contact window for the source region 25 is formed at the boundary portion of the source region 25 so that the source electrode 29 has contact with both the source region 25 and the silicon substrate 21 through a polycrystalline silicon layer 30. Accordingly, in the semiconductor device of Fig. 9, the source region 25 and the silicon substrate 21 are electrically connected through the source electrode 29.

As described above, in accordance with the semiconductor device according to the present invention, the area necessary for forming an integrated circuit can be decreased so that the scale of integration of the integrated circuit can be increased. However, since a silicon substrate has rather low conductivity, the present invention is preferably applied to a small supply current circuit, such as a complementary metal-oxide semiconductor (CMOS) circuit.

If a semiconductor device comprises both small current MIS transistors and rather large current MIS transistor, it is preferable that the source regions of the small current MIS transistors be connected directly to the substrate, and the source regions of the large current MIS transistors be connected to the reference voltage wiring lines through the contact windows.

Figure 10 is a schematic cross-sectional view of such a semiconductor device. In Fig. 10, corresponding portions are given with the same reference numerals as in Figs. 2 and 5.

## Claims

1. A semiconductor device comprising at least one metal-insulator-semiconductor field effect transistor formed on a semiconductor substrate (21), the field effect transistor comprising a drain region (24) and a source region (25) of one conductivity type formed in a region of the semiconductor substrate (21) of another conductivity type, the device further comprising means (34, 30) forming a direct electrical connection between the source region (25) and the semiconductor substrate (21) characterised in that said means (34, 30) provides the sole electrical connection between the said source region (25) and a wiring line provided on the back surface of the substrate.

2. A semiconductor device according to claim 1, further comprising a drain electrode having a polycrystalline silicon layer (30) formed on the surface of the drain region (24) and a metal layer (27) formed on the polycrystalline silicon layer (30), and a source electrode having a metal layer (29) formed directly on the surface of the source region (25), metal from the metal layer (29) of the source electrode being impregnated into the source region (25) and into the semiconductor substrate (21) to form the means (34) forming a direct electrical connection between the source region (25) and the substrate (21).

3. A semiconductor device according to claim 1, further comprising a source electrode consisting of a metal layer (29) formed directly on the surface of the source region (25), metal from the metal layer (29) of the source electrode being impregnated into the source region (25) and into the semiconductor substrate (21), to form the means (34) forming a direct electrical connection between the source region (25) and the substrate (21), and drain electrode consisting of a metal layer (27) formed directly on the surface of the drain region (24), the depth of the drain region (24) being greater than the source region (25) and being such that the metal impregnated into the drain region (24) from the drain electrode (27) does not reach the semiconductor substrate (21).

4. A semiconductor device according to claim 1, further comprising drain and source electrodes each including a polycrystalline silicon layer (30) formed on the surface of the drain (24) and source (25) regions, respectively, the polycrystalline source elelctrode (30) extending across onto the surface of the semiconductor substrate (21) so that the polycrystalline silicon layer (30) of the source elelctrode is in contact with both the source region (25) and the semiconductor substrate (21) and forms the means forming a direct electrical connection between the source region (25) and the substrate (21).

5. A semiconductor device according to any one of the preceding claims, further comprising a reference voltage wiring line (4) formed on the surface of the semiconductor substrate (9, 21) but not directly electrically connected to the substrate (9, 21) and another field effect transistor (6, 7, 8) having a source region (7) which is connected to the reference voltage wiring line (4).

## Patentansprüche

1. Halbleitervorrichtung mit wenigstens einem auf einem Halbleitersubstrat (21) gebildeten Metall-Isolator-Halbleiter-Feldeffekttransistor, der einen Drainbereich (24) und einen Sourcebereich (25) von einem Leitfähigkeitstyp umfaßt, die in einem Bereich des Halbleitersubstrats (21) eines anderen Leitfähigkeitstyps gebildet sind, welche Vorrichtung ferner Einrichtungen (34, 30) umfaßt, die eine direkte elektrische Verbindung zwischen dem Sourcebereich (25) ·und dem Halbleitersubstrat (21) bilden, dadurch gekennzeichnet, daß die genannte Einrichtung (34, 30) die einzige elektrische Verbindung zwischen dem genannten Sourcebereich (25) und einer Verdrahtungsleitung darstellt, die auf der rückwärtigen Oberfläche des Substrats vorgesehen ist.

2. Halbleitervorrichtung nach Anspruch 1, ferner mit einer Drainelektrode, die eine polykristalline Siliziumschicht (30) hat, die auf der Oberfläche des Drainbereiches (24) gebildet ist, und einer Metallschicht (27), die auf der polykristallinen Siliziumschicht (30) gebildet ist, und einer Sourceelektrode, die eine Metallschicht (29) hat, die direkt auf der Oberfläche des Sourcebereiches (25) gebildet ist, wobei Metall von der Metallschicht (29) der Sourceelektrode in den Sourcebereich (25) und in das Halbleitersubstrat (21) imprägniert ist, um die Einrichtung (34) zu formen, die eine direkte elektrische Verbindung zwischen dem Sourcebereich (25) und dem Substrat (21) bildet.

3. Halbleitervorrichtung nach Anspruch 1, ferner mit einer Sourceelektrode, die aus einer Metallschicht (29) besteht, die direkt auf der Oberfläche des Sourcebereichs (25) gebildet ist, wobei Metall von der Metallschicht (29) der Sourceelektrode in den Sourcebereich (25) und in das Halbleitersubstrat (21) imprägniert ist, um die Einrichtung (34) zu bilden, die eine direkte elektrische Verbindung zwischen dem Sourcebereich (25) und dem Substrat (21) bildet, und die Drainelektrode aus einer Metallschicht (27) besteht, die direkt auf der Oberfläche des Drainbereiches (24) gebildet ist, wobei die Tiefe des Drainbereiches (24) größer als der Sourcebereich (25) und derart ist, daß das Metall, das von der Drainelektrode (27) in den Drainbereich (24) imprägniert ist, nicht das Halbleitersubstrat (21) erreicht.

4. Halbleitervorrichtung nach Anspruch 1, ferner mit Drain und Sourceelektroden, die jeweils eine polykristalline Siliziumschicht (30) aufweisen, die auf der Oberfläche der Drainbereiche (24) bzw. der Sourcebereiche (25) gebildet ist, wobei die polykristalline Sourceelektrode (30) sich quer auf der Oberfläche des Halbleitersubstrats (21) erstreckt, so daß die polykristalline Siliziumschicht (30) der Sourceelektrode mit sowohl dem Sourcebereich (25) als auch dem Halbleitersubstrat (21) in Kontakt ist und die Einrichtung bildet, welche eine direkte elektrische Verbindung zwischen dem Sourcebereich (25) und dem Substrat (21) bildet.

5. Halbleitervorrichtung nach einem der vorhergehenden Ansprüche, ferner mit einer Referenzspannungs-verdrahtungsleitung (4), die auf der Oberfläche des Halbleitersubstrats (9, 21) gebildet ist, aber nicht direkt elektrisch mit dem Substrat (9, 21) verbunden ist, und einem anderen Feldeffekttransistor (6, 7, 8), der einen Sourcebereich (7) hat, der mit der Referenzspannungs-verdrahtungsleitung (4) verbunden ist.

## Revendications

1. Dispositif à semiconducteur comprenant au moins un transistor à effet de champ à métal-isolant-semiconducteur formé sur un substrat semiconducteur (21), le transistor à effet de champ comprenant une région de drain (24) et une région de source (25) d'un type de conductivité formées dans une région du substrat semiconducteur (21) d'un autre type de conductivité, le dispositif comprenant en outre un moyen (34, 30) constituant une connexion électrique directe entre la région de source (25) et le substrat semiconducteur (21), caractérisé en ce que le moyen (34, 30) fournit la seule connexion électrique entre la région de source (25) et une ligne de câblage prévue sur la surface arrière du substrat.

2. Dispositif à semiconducteur selon la revendication 1, comprenant en outre une électrode de drain comportant une couche de silicium polycristallin (30) formée sur la surface de la région de drain (24) et une couche de métal (27) formée sur la couche de silicium polycristallin (30), et une électrode de source comportant une couche de métal (29) formée directement sur la surface de la région de source (25), du métal de la couche de métal (29) de l'électrode de source pénétrant dans la région de source (25) et dans le substrat semiconducteur (21) pour former le moyen (34) constituant une connexion électrique directe entre la région de source (25) et le substrat (21).

3. Dispositif à semiconducteur selon la revendication 1, comprenant en outre une électrode de source constituée d'une couche de métal (29) formée directement sur la surface de la région de source (25), du métal de la couche de métal (29) de l'électrode de source pénétrant dans la région de source (25) et dans le substrat semiconducteur (21), pour former le moyen (34) constituant une connexion électrique directe entre la région de source (25) et le substrat (21), et une électrode de drain constituée d'une couche de métal (27) formée directement sur la surface de la région de drain (24), la profondeur de la région de drain (24) étant supérieure à celle de la région de source (25) et étant telle que le métal pénétrant dans la région de drain (24) à partir de l'électrode de drain (27) n'atteint pas le substrat semiconducteur (21).

4. Dispositif à semiconducteur selon la revendication 1, comprenant en outre des électrodes de drain et de source incluant chacune une couche de silicium polycristallin (30) formée sur la surface des régions de drain (24) et de source (25), respectivement, l'électrode de source poly-cristalline (30) s'étendant en travers jusque sur la surface du substrat semiconducteur (21) de sorte que la couche de silicium polycristallin (30) de l'électrode de source est en contact avec à la fois la région de source (25) et le substrat semiconducteur (21) et forme le moyen constituant une connexion électrique directe entre la région de source (25) et le substrat (21).

5. Dispositif à semiconducteur selon l'une quelconque des revendications 1 à 4, comprenant en outre une ligne de câblage de tension de référence (4) formée sur la surface du substrat semiconducteur (9, 21) mais non directement connectée électriquement au substrat (9, 21) et un autre transistor à effet de champ (6, 7, 8) comportant une région de source (7) qui est connectée à la ligne de câblage de tension de référence (4).

*Fig. I*

*Fig. 2*

# Fig. 3

# Fig. 4

## Fig. 5

26

24          34   25          21

10

## Fig. 6

1     1

1

2     3

5

## Fig. 7

## Fig. 8

## Fig. 9

## Fig. 10